Europäisches Patentamt

European Patent Office

Office européen des brevets

(11) Veröffentlichungsnummer: **0 123 301**
**B1**

(12) **EUROPÄISCHE PATENTSCHRIFT**

(45) Veröffentlichungstag der Patentschrift: **27.12.90**

(51) Int. Cl.⁵: **G 03 F 7/09**

(21) Anmeldenummer: **84104502.4**

(22) Anmeldetag: **19.04.84**

(54) **Verfahren zur fotolithografischen Herstellung von Strukturen nach dem Prinzip der Abhebetechnik.**

(30) Priorität: **22.04.83 DE 3314602**

(43) Veröffentlichungstag der Anmeldung:
**31.10.84 Patentblatt 84/44**

(45) Bekanntmachung des Hinweises auf die
Patenterteilung:
**27.12.90 Patentblatt 90/52**

(84) Benannte Vertragsstaaten:
**AT DE IT NL SE**

(56) Entgegenhaltungen:
**DE-A-3 138 761**
**GB-A- 785 858**
**GB-A-2 040 498**

**INTERNATIONAL ELECTRON DEVICES
MEETING, San Francisco, US, 13.-15. Dezember
1982, Seiten 399-402, IEEE, New York, US; Y.-C.
LIN et al.: "Linewidth control using anti-
reflective coating for optical lithography"**

(73) Patentinhaber: **Siemens Aktiengesellschaft
Wittelsbacherplatz 2
D-8000 München 2 (DE)**

(72) Erfinder: **Bulst, Wolf-Eckhart, Dipl.-Phys.
Arnikastrasse 2
D-8011 Vaterstetten (DE)**
Erfinder: **Keinath, Peter, Dipl.-Ing.
Rablstrasse 16
D-8000 München 80 (DE)**
Erfinder: **Lindemann, Gertrud
Kolumbusstrasse 16
D-8000 München 90 (DE)**

(56) Entgegenhaltungen:
**J. APPL. PHYS., Band 50, Nr. 3, März 1979,
Seiten 1212-1214, American Institute of Physics,
US; H.A.M. VAN DEN BERG et al.:**

**"Antireflection coatings on metal layers for
photolithographic purposes"**

**Beschreibung**

Die vorliegende Erfindung bezieht sich auf eine Verbesserung zu einem lichtoptischen, fotolithografischen Verfahren, wie es im Oberbegriff des Patentanspruchs 1 angegeben ist.

Aus der DE-OS 15 97 597 ist ein Verfahren zur Reduzierung der Unterstrahlungseffekte bei Kopierverfahren der grafischen Technik bekannt, bei dem eine fotoempfindliche Schicht auf der für den Druck vorgesehenen Metallplatte entsprechend dem Druckmuster belichtet wird. Es ist dort vorgesehen, zwischen der Oberfläche der Metallplatte und der darauf befindlichen fotoempfindlichen Schicht zusätzlich noch eine Zwischenschicht vorzusehen, die die für den fotolithografischen Prozeß verwendete Strahlung absorbiert, d.h. Reflexion derartiger Strahlung ausschließt.

Auch in der Halbleitertechnologie hat man dieses Pinzip angewendet. In der US-PS 3 884 698 ist beschrieben, zwischen der auf einem Halbleitersubstrat befindlichen, stellenweise zu ätzenden Isolationsschicht aus insbesondere Siliziumdioxid und der auf dieser Oxidschicht befindlichen fotoempfindlichen Schicht eine Antireflexschicht vorzusehen, um optische Interferenzen zu verhindern.

Wiederum zwischen der zu bearbeitenden Schaltungsplatte für gedruckte Schaltungen und der für die Fotolithografie verwendeten fotoempfindlichen Schicht hat man auch, wie in der DE-AS 11 09 226 beschrieben, eine reflexionsvermindernde Schicht vorgesehen, die auch ätzfähig ist.

Sachlich gleiches beschreiben auch die GB-A-20 40 498 und die Druckschrift "International Electron Devices Meeting, San Francisco, US, 13.15. Dezember 1982, Seiten 399-402, IEEE New York, US; Y.-C. Lin et al.: "Linewidth control using anti-reflective coating for optical lithography", und zwar für die Herstellung geätzter Metallmasken. Die zwischen der fotoempfindlichen Schicht und dem darunter liegenden, zu ätzenden Metall der Maske vorgesehene Antireflexschicht dient dazu, ansonsten in der fotoempfindlichen Schicht, und zwar weil noch innerhalb des Kohärenzlängenbereichs der Belichtungsstrahlung befindlich, auftretende stehende Wellen dieser Strahlung zu vermeiden. Damit wird die für die Homogenität des Belichtungseffekts in der Schicht ansonsten auftretende nachteilige Wirkung solcher stehender Wellen ausgeschlossen. Eine solche Antireflexschicht ist z.B. eine durch Oxidation erzeugte dielektrische Schicht aus Titandioxid auf dem Titan des Materials der zu ätzenden Maske oder z.B. eine Siliziumschicht auf zu ätzendem Aluminium.

Oliner beschreibt in "Acoustic Surface Waves", Springer Verlag, 1978, Seiten 320-322, ein spezielles Verfahren der Fotolithografie, nämlich das der Abhebetechnik (lift off technique), mit dem sich vorteilhaft feine Metallstrukturen, wie sie für Oberflächenwellen-Anordnungen erforderlich sind, herstellen lassen. Dieses Verfahren ist auch in der älteren, nicht vorveröffentlichten deutschen Patentanmeldung P 31 38 761.6 beschrieben. Bei der Durchführung dieses Verfahrens wird auf einem Substratkörper zunächst eine Schicht aus einem für Fotolithografie zu verwendenden Fotolack aufgebracht, der der geforderten Struktur entsprechend belichtet wird. Es erfolgt dann das Entwickeln des Fotolackes. Dabei werden die belichteten Flächenanteile der Fotolackschicht abgelöst, so daß die Oberfläche des Substrats frei wird. Nachfolgend wird die gesamte Oberfläche derart mit einer Metallschicht überzogen, daß an den entwickelten Stellen sich die Metallschicht direkt auf dem Substrat und an den nicht belichteten Stellen sich auf dem Fotolack befindet. Vorzugsweise mit Hilfe von Azeton werden dann die auf dem Substrat verbliebenen Reste, nämlich an den nicht belichteten Stellen des Fotolackes, abgelöst, womit auch die darauf befindlichen Anteile der Metallbeschichtung entfernt werden.

Dieses Verfahren wird auch für die Herstellung von solchen Strukturen benutzt, die sehr unterschiedliche Größe der einzelnen, dicht beieinanderliegenden Belichtungsflächen haben. Nach dem bekannten Verfahren solche Strukturen herzustellen hat sich aber als problematisch erwiesen. Dieses Problem ist gleichermaßen aufgetreten unabhängig davon, ob man die feinen Strukturen gleichzeitig mit einer großflächigen Struktur belichtet hat oder ob man diese prinzipiell verschiedenen Strukturen in Nacheinanderfolge belichtet hat. Dieses Problem bestand darin, daß das frequenzmäßige Verhalten derartiger hergestellter Strukturen nicht den Vorgaben entsprach und/oder Unterschiede im frequenzmäßigen Verhalten zwischen solchen Strukturen vorlagen, die in an sich demselben Prozeßdurchlauf hergestellt worden sind. Man ist den zunächst unerklärlichen Abweichungen des Frequenzverhaltens der einzelnen hergestellten Strukturen nachgegangen und man hat festgestellt, daß die hergestellten feinen Strukturanteile tatsächlich nicht der geforderten Präzision entsprachen, d.h. von den gemachten Vorgaben Abweichungen aufwiesen.

Es ist eine Aufgabe der vorliegenden Erfindung, eine Verbesserung eines wie oben beschriebenen Verfahrens anzugeben, mit dem auch einzelne dicht beieinanderliegende, jedoch in ihrer Flächenausdehnung sehr unterschiedliche Strukturflächen, z.B. einzelne feine Streifen neben einem großen Anschlußbereich, in einwandfreier Qualität herzustellen sind.

Diese Aufgabe wird für ein Verfahren nach dem Oberbegriff des Patentanspruchs 1 gemäß der Lehre des Kennzeichens dieses Anspruchs gelöst. Weitere Ausgestaltungen und Weiterbildungen der Erfindung gehen aus den Unteransprüchen hervor.

Die Erfinder haben festgestellt, daß die auftretenden Unzulänglichkeiten bei der fotolithografischen Herstellung von Feinstrukturen neben großflächigen Strukturen weder durch Wahl der Folge der Belichtungsprozesse noch durch Intensitätsunterschiede des zur Belichtung verwendeten Lichtes zu beheben sind. Vielmehr wurde festgestellt, daß die aufgetretenen Mängel auf Reflexionen an der Rückseite des Substrats, das für das verwendete Licht durchlässig ist, beruhen. Insbesonders stark sind die Störungen nämlich bei einem rückseitig aufgerauhtem Substrat, wie es für Oberflächenwellen-Anordnungen bevorzugt verwendet wird, wo diese Aufrauhung dazu dient, Volumenwellen-Reflexionen zu beseitigen. Die Maßnahme zur Beseitigung der Reflexionen der einen Wellenart bewirkt somit die Schwierigkeiten, die im Zusammenhang mit Wellen einer anderen Art verstärkt werden. Eine Beschichtung der insbesondere aufgerauhten Rückseite des Substrats mit z.B. Schwarzchrom ($Cr_2O_3$) oder mit Silizium führt zu völlig ausreichender Beseitigung der Ursachen, die die Herstellung solcher wie oben angegebener Strukturen mit einfach zu handhabendem lichtoptischen, fotolithografischen Verfahren praktisch unmöglich gemacht haben. Bei der Verwendung von Silizium als wenigstens reflexionsmindernde Schicht haben sich zwei Varianten als vorteilhaft erwiesen; nämlich entweder amorphes Silizium mit vorzugsweise einer Dicke von 50 bis 200 nm aufzudampfen oder aufzusputtern (Kathodenzerstäubung) oder eine Mehrfachbeschichtung vorzunehmen. Diese Mehrfachbeschichtung besteht aus einer ersten auf der Substratrückseite aufgebrachten Siliziumschicht und einer darauffolgenden undurchlässigen Schicht aus Metall, wie z.B. Chrom oder Aluminium. Überraschenderweise hat sich gezeigt, daß man besonders hohe Reflexionsverminderung erzielt, wenn man für Licht der g- und/oder h-Linie des Quecksilberspektrums diese Siliziumschicht nur 10 bis 14 nm dick macht. Für diese Dicke ergibt sich für diese Strahlung ein ausgesprochenes Optimum, doch ist das Maß der Reflexionsverminderung auch bei Siliziumschichten mit größerer Dicke noch sehr günstig.

Die Substrate bestehen vorzugsweise aus Glas oder — soweit Piezoelektrizität gefordert ist — aus Quarz oder aus Lithiumniobat bzw. Lithiumtantalat, die für die angegebene Quecksilber-Ultraviolettstrahlung durchlässig sind. Die Erfindung ist besonders vorteilhaft bei Lithiumniobat bzw. -tantalat wegen deren hohem Brechungsindex.

Weitere Erläuterungen der Erfindung gehen aus der nachfolgenden, anhand der Figuren gegebenen Beschreibung hervor.

Fig. 1 zeigt einen Anwendungsfall für eine Interdigitalstruktur mit Anschlußpads.

Fig. 2 zeigt eine Anwendung für eine Konvolver-Struktur.

Fig. 3 zeigt eine Seitenansicht eines Substrats mit den entsprechenden Beschichtungen des fotolithografischen Verfahrens nach der Erfindung.

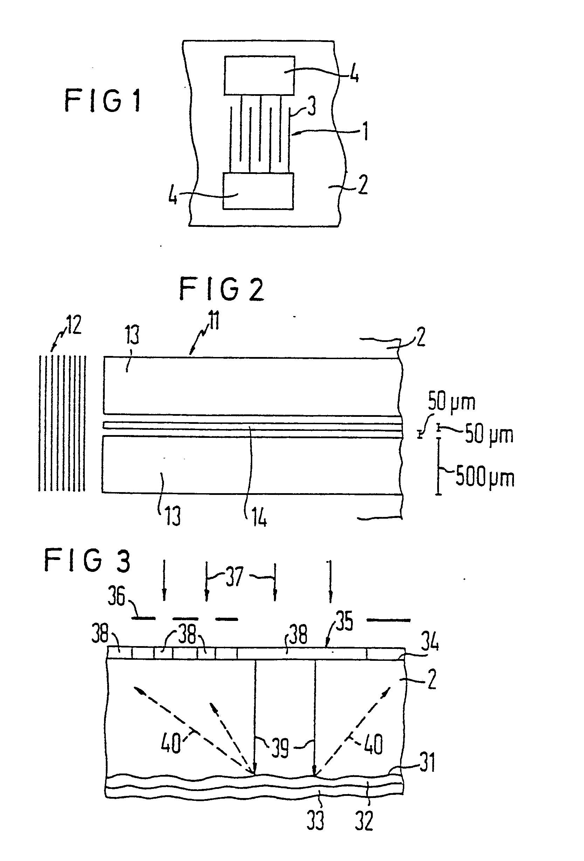

In Fig. 1 ist mit 1 eine Interdigital-Wandlerstruktur auf einem Substrat 2 bezeichnet. Die Struktur 1 besteht aus einerseits sehr schmalen Elektrodenfingern 3 mit einer Breite von z.B. 1 µm. Mit 4 sind Anschlußpads bzw. Busleitungen bezeichnet, die dem elektrischen Anschluß der Streifen 3 dienen. Diese Pads 4 können Flächen in der Größenordnung von mm² haben.

Fig. 2 zeigt mit 11 eine Konvolver-Anordnung mit einer Streifenstruktur 12, bestehend aus feinen Streifen vergleichsweise den Streifen 3 der Fig. 1. Dicht neben dieser Streifenstruktur 12 schließen sich die Flächenelektroden 13 und 14 an, wobei die Streifen 13 eine Breite von beispielsweise 500 µm und der Streifen 14 eine Breite von 50 µm bei 50 µm Abstand untereinander haben. Auch die Fig. 2 läßt erkennen, was unter der obigen Beschreibung zu verstehen ist: "Einzelne Streifen mit feiner Struktur neben großen Flächen".

In Fig. 3 ist wieder mit 2 das Substrat aus beispielsweise Quarz bezeichnet. Die Rückseite 31 des Substrats 2 ist, wie oben angegeben, aufgerauht. Auf dieser aufgerauhten Oberfläche 31 befindet sich entsprechend der einen Variante der Erfindung eine erste Schicht 32 aus Silizium und darauf die (äußere) Schicht 33 aus beispielsweise Aluminium.

Auf der Oberfläche 34 des Substrats 2 ist eine durchgehende Fotolackschicht 35 zu erkennen. Zum Beispiel durch eine Maske 36 hindurch erfolgt die an sich ganzflächige Belichtung 37 der Fotolackschicht 35. Mit 38 sind Bereiche dieser Fotolackschicht kenntlich gemacht, die bestrahlt werden und in denen nach Entwicklung der Fotolack der Schicht 35 entfernt ist. Mit 39 ist auf Lichtstrahlung hingewiesen, die durch das Substrat 2 hindurch die Rückseite 31 desselben erreichen kann. Mit 40 ist auf eine an der Rückseite reflektierte Strahlung hingewiesen. Diese Strahlung 40 ist gestrichelt dargestellt, weil sie bei der Erfindung praktisch völlig ausgeschlossen ist. Wie angedeutet, könnte nämlich solche Strahlung 40 aus dem Substrat 2 heraus die Fotolackschicht 35 an denjenigen Stellen, insbesondere im Bereich der feinen Struktur, unerwünschterweise belichten, nämlich an Stellen, an denen mit Hilfe der Maske 36 an sich jegliche Belichtung verhindert sein soll. Durch das Wegfallen einer Reflexion 40 gemäß der erfindungsgemäßen Verbesserung des an sich bekannten Verfahrens hat man auch nach der Belichtung zwischen diesen Anteilen 38 der Fotolackschicht 35 weiterhin einwandfrei abdeckenden Fotolack.

Von besonderer Bedeutung ist die vorliegende Erfindung dann, wenn — wie dies weitverbreitete Praxis ist — derartige Substrate auf einem Chuck angeordnet und gehalten werden. Ein 'Chuck' ist eine Unterlage, auf der ein wie hier in Frage kommendes Substrat mittels Ansaugen bzw. mittels Vakuum festgehalten wird. Die Oberfläche eines derartigen Chuck besitzt Kerben, Rillen oder dergleichen und Löcher, durch die Luft abgesaugt werden kann. Soweit diese Rillen, Kerben und Löcher durch das Substrat überdeckt sind, wird das Substrat fest an die Oberfläche des Chuck angesaugt. Führt man ein wie oben beschriebenes Verfahren der Fotolithografie aus, und zwar bei einem für das Licht durchlässigen Substrat, so spielt auch die Struktur der Oberfläche dieses Chuck eine Rolle, obwohl dieses Chuck nichts mit der herzustellenden Struktur zu tun hat und dementsprechend auch keine Beachtung findet. Insbesondere die Löcher des Chuck sind für die für den fotolithografischen Prozeß auffallende Strahlung 37 wie optisch schwarze Körper wirksam. Dies führt dazu, daß die Oberflächenstruktur des Chuck eingeht in das Maß auftretender Rückreflexion und Einfluß auf Einzelheiten der herzustellenden Struktur gewinnt. Einzelne auf einem Substrat hergestellte Strukturen hatten trotz identischer Vorgabe frequenzmäßig unterschiedliche Eigenschaften. Die daraufhin angestellten Untersuchungen führten dazu, daß hierfür solche Schwankungen der Fingerbreiten verantwortlich sind, die durch optische Meßtechnik nur äußerst schwierig und erst mit der gewonnenen Erkenntnis eines solchen Zusammenhanges nachzuweisen sind. Es wurde festgestellt, daß die Position der jeweiligen Struktur zu derartigen Löchern des Chuck eine wesentliche Rolle spielte. Auch dieses voranstehende Problem ist mit der Erfindung gelöst, nämlich dadurch, daß die erfindungsgemäß vorgesehene Rückreflexion vermindernde Schicht eine solche Beeinflussung verhindert. Insbesondere gilt dies für eine solche Ausführungsform der Erfindung, bei der eine Schichtkombination aus Rückreflexion vermindernder Schicht und darauf befindlicher Metallschicht (z.B. Kombination einer Siliziumschicht mit einer Aluminiumschicht) verwendet worden ist.

**Patentansprüche**

1. Verfahren zur lichtoptischen fotolithografischen Herstellung von Strukturen für Oberflächenwellen-Anordnungen auf einem Substrat (2), das für die bei diesem Verfahren verwendete Quecksilber-Ultraviolettstrahlung (37) durchlässig (39) ist,
wobei das Verfahren ein solches nach dem Prinzip der Abhebetechnik ist,
wobei sich das Substrat (2) während der Durchführung des Belichtungsprozesses auf einer mit Kerben, Rillen oder dgl. versehenen Ansaug-Unterlage (chuck) befindet,
wobei die auf der Unterlage (chuck) aufliegende Rückseite des Substrats (2) eine aufgerauhte Substratoberfläche (31) ist,
gekennzeichnet dadurch, daß vor dem Ausführen der Fotolithografie (35 bis 38) auf dieser aufgerauhten Substratoberfläche (31) eine erste Schicht (32) aus Silizium nach einem der Verfahren des Aufdampfens und Aufsputterns aufgebracht,
daß auf diese Siliziumschicht (32) eine weitere Schicht (33) aus einem für die Quecksilber-Ultraviolettstrahlung (37) undurchlässigen Metall aufgebracht wird und
daß die Schichtdicke der ersten Schicht (32) auf das sich ergebende Optimum der Reflexionsverminderung bemessen wird.

2. Verfahren zur lichtoptischen fotolithografischen Herstellung von Strukturen für Oberflächenwellen-Anordnungen auf einem Substrat (2), das für die bei diesem Verfahren verwendete Quecksilber-Ultraviolettstrahlung (37) durchlässig (39) ist,
wobei das Verfahren ein solches nach dem Prinzip der Abhebetechnik ist,
wobei sich das Substrat (2) während der Durchführung des Belichtungsprozesses auf einer mit Kerben, Rillen oder dgl. versehenen Ansaug-Unterlage (chuck) befindet, wobei die auf der Unterlage (chuck) aufliegende Rückseite des Substrats (2) eine aufgerauhte Substratoberfläche (31) ist,
gekennzeichnet dadurch, daß vor dem Ausführen der Fotolithografie (35 bis 38) auf dieser aufgerauhten Substratoberfläche (31) eine Schicht (32) aus Silizium nach einem der Verfahren des Aufdampfens und Aufsputterns aufgebracht und
daß die Schichtdicke auf 50 nm bis 200 nm bemessen wird.

3. Verfahren nach Anspruch 1, gekennzeichnet dadurch, daß als undurchlässiges Metall Aluminium verwendet wird.

4. Verfahren nach Anspruch 1, gekennzeichnet dadurch, daß die Dicke der ersten Schicht (32) auf 10 nm bis 14 nm bemessen wird.

5. Verfahren nach einem der Ansprüche 1 bis 4, angewendet für ein Substrat aus Quarz.

6. Verfahren nach einem der Ansprüche 1 bis 4, angewendet für ein Substrat aus Lithiumniobat.

7. Verfahren nach einem der Ansprüche 1 bis 4, angewendet für ein Substrat aus Lithiumtantalat.

8. Verfahren nach einem der Ansprüche 1 bis 4, angewendet für ein Substrat aus Glas.

9. Anwendung eines Verfahrens nach einem der Ansprüche 1 bis 8, für Oberflächenwellen-Anordnungen mit Strukturen mit Breiten kleiner/gleich 1 µm.

10. Anwendung nach Anspruch 9 für eine Convolver-Anordnung.

**Revendications**

1. Procédé de fabrication opto-photolithographique de structures pour des dispositifs à ondes de surface sur un substrat (2), qui est transparent (39) au rayonnement ultraviolet (37) du mercure utilisé dans ce procédé, le procédé étant un procédé suivant le principe de la technique du décollement et du type dans lequel le substrat (2) se trouvent, pendant que s'effectue le processus d'exposition, sur un support (chuck) d'aspiration, muni d'encoches, de sillons ou analogue, et la face arrière du substrat (2), reposant sur le support (chuck), est une surface de substrat (31) rugueuse,
caractérisé en ce qu'il consiste,
avant d'effectuer la photolithographie (35 à 38), à déposer sur cette surface rugueuse du substrat (31), une première couche (32) en silicium suivant l'un des procédés du dépôt en phase vapeur et de la pulvérisation cathodique,
à déposer sur cette couche de silicium (32) une autre couche (33) en un métal imperméable au rayonnement ultraviolet du mercure (37), et
à proportionner l'épaisseur de la première couche (32) à l'optimum de diminution de réflexion qui en résulte.

2. Procédé de fabrication opto-photolithographique de structures pour des dispositifs à ondes de surface sur un substrat (2), qui est transparent (39) au rayonnement ultraviolet (37) du mercure utilisé dans ce procédé, le procédé étant un procédé suivant le principe de la technique du décollement, du type dans lequel le substrat (2) se trouve, pendant que s'effectue le processus d'exposition, sur un support (chuck) d'aspiration, muni d'encoches, de sillons ou analogue, et la face arrière du substrat (2), reposant sur le support (chuck), est une surface de substrat rugueuse (31),

caractérisé en ce qu'il consiste,

avant d'effectuer la photolithographie (35 à 38), à déposer sur cette surface du substrat rugueuse (31), une première couche (32) en silicium suivant l'un des procédés du dépôt en phase vapeur et de la pulvérisation cathodique, et

à donner à la couche une épaisseur comprise entre 50 nm et 200 nm.

3. Procédé suivant la revendication 1, caractérisé en ce qu'il consiste, à utiliser, comme métal imperméable, de l'aluminium.

4. Procédé suivant la revendication 1, caractérisé en ce qu'il consiste, à donner à la première couche (32) une épaisseur comprise entre 10 nm et 14 nm.

5. Procédé suivant l'une des revendications 1 à 4, utilisé pour un substrat en quartz.

6. Procédé suivant l'une des revendications 1 à 4, utilisé pour un substrat en niobate de lithium.

7. Procédé suivant l'une des revendications 1 à 4, utilisé pour un substrat en tantalate de lithium.

8. Procédé suivant l'une des revendications 1 à 4, utilisé pour un substrat en verre.

9. Utilisation d'un procédé suivant l'une des revendications 1 à 8, pour des dispositifs à ondes de surface ayant des structures de largeur égale ou inférieure à 1 µm.

10. Utilisation suivant la revendication 9 pour un dispositif convolutionneur.

**Claims**

1. Process for light-optical photolithographic production of structures for surface wave arrangements on a substrate (2) that is transparent (39) to the mercury ultraviolet radiation (37) used in said process, the process being such as accords with the principle of the lift-off technique, the substrate (2) being located during the carrying out of the exposure process on a suction support (chuck) provided with notches, grooves, or the like, the rear side of the substrate (2) bearing against the support (chuck) being a roughened substrate surface (31), characterized in that before carrying out the photolithography (35 to 38) a first layer (32) made of silicon is applied to this roughened substrate surface (31) in accordance with one of the processes of vapour deposition and sputtering, in that a further layer (33) made of a metal that is opaque to the mercury ultraviolet radiation (37) is applied to this silicon layer (32), and in that the layer thickness of the first layer (32) is dimensioned to the resulting optimum of the reduction in reflection.

2. Process for light-optical photolithographic production of structures for surface wave arrangements on a substrate (2) that is transparent (39) to the mercury ultraviolet radiation (37) used in said process, the process being such as accords with the principle of the lift-off technique, the substrate (2) being located during the carrying out of the exposure process on a suction support (chuck) provided with notches, grooves, or the like, the rear side of the substrate (2) bearing against the support (chuck) being a roughened substrate surface (31), characterized in that before carrying out the photolithography (35 to 38) a layer (32) made of silicon is applied to this roughened substrate surface (31) in accordance with one of the processes of vapour deposition and sputtering, and in that the layer thickness is dimensioned to 50 nm to 200 nm.

3. Process according to Claim 1, characterized in that aluminium is used as the opaque metal.

4. Process according to Claim 1, characterized in that the thickness of the first layer (32) is dimensioned to 10 nm to 14 nm.

5. Process according to one of Claims 1 to 4, applied to a substrate made of quartz.

6. Process according to one of Claims 1 to 4, applied to a substrate made of lithium niobate.

7. Process according to one of Claims 1 to 4, applied to a substrate made of lithium tantalate.

8. Process according to one of Claims 1 to 4, applied to a substrate made of glass.

9. Application of a process according to one of Claims 1 to 8, for surface wave arrangements comprising structures with widths of less than/equal to 1 µm.

10. Application according to Claim 9 for a convolver arrangement.

FIG 1

FIG 2

FIG 3